# EUROPEAN PATENT APPLICATION

(11) **EP 2 682 497 A1**
(43) Date of publication of application: **08.01.2014**
(21) Application number: 12751723.3
(22) Date of filing: 13.02.2012
(51) Int. Cl.: C23C 14/34, H01L 21/316

(54) **METHOD FOR STORING METALLIC LANTHANUM TARGET, VACUUM-SEALED METALLIC LANTHANUM TARGET, AND THIN FILM FORMED BY SPUTTERING USING METALLIC LANTHANUM TARGET**

(30) Priority: 01.03.2011 JP 2011043915
(71) Applicant: JX Nippon Mining & Metals Corporation, Tokyo 100-8164 (JP)
(72) Inventor: NARITA Satoyasu, Kitaibaraki-shi Ibaraki 319-1535 (JP); SATOH Kazuyuki, Kitaibaraki-shi Ibaraki 319-1535 (JP); KOIDO Yoshimasa, Kitaibaraki-shi Ibaraki 319-1535 (JP)
(74) Representative: Liesegang, Eva
(86) International application number: PCT/JP2012/053242
(87) International publication number: WO 2012/117834

(57) **Abstract**

A method of storing a metal lanthanum sputtering target, wherein a surface of a metal lanthanum target to be stored is processed so as to achieve a roughness Ra of 1 µm or less, a lanthanum fluoride coating is formed on the surface thereof, the metal lanthanum target to which the lanthanum fluoride coating was formed is subsequently charged in a vacuum pack with an oxygen transmission rate of 0.1 cm³/m² per 24 h at 1 atm or less and a moisture vapor transmission rate of 0.1 g/m² per 24 h or less, and the vacuum pack is thereafter subject to vacuum suction and sealing for storage. This invention aims to provide technology for enabling the long-term storage of a sputtering target in a usable state by devising the method of storing a metal lanthanum target as a rare earth metal, and thereby inhibiting the degradation phenomenon caused by the oxidation of the target due to residual air or the inclusion of air.

## Description

### [Technical Field]

The present invention relates to a method of storing a metal lanthanum target that degrades easily due to hydroxylation, a vacuum-sealed metal lanthanum target, and a thin film formed by sputtering the metal lanthanum target that was released from its vacuum seal and removed from the vacuum pack.

### BACKGROUND

Lanthanum as a rare earth metal is contained in the earth's crust as a mixed composite oxide. Rare-earth elements are called "rare-earth" elements because they are separated from relatively rare minerals, but they are not that rare in light of the overall earth's crust. In recent years, rare earth metals are attracting attention as an electronic material, and research and development for using rare earth metals are being promoted.

Among the rare earth metals, lanthanum (La) is attracting particular attention. To briefly introduce lanthanum, lanthanum is a white metal having an atomic number of 57 and an atomic weight of 138.9, and comprises a double hexagonal close-packed structure at normal temperature. Lanthanum has a melting point of 921°C, boiling point of 3500°C, and density of 6.15 g/cm³, its surface is oxidized in the atmosphere, and gradually melts in water.

Lanthanum is soluble in hot water and acid and, although it is not ductile, it is slightly malleable. Lanthanum's resistivity is 5.70 x 10⁻⁶Ωcm, and it becomes oxide (La₂O₃) when burned at 445°C or higher (refer to Dictionary of Physics and Chemistry). With rare earth elements, it is generally said that compounds with the oxidation number 3 are stable, and lanthanum is also trivalent.

Lanthanum is a metal that is attracting attention as an electronic material such as a metal gate material or a high-dielectric (High-k) material. Rare earth elements other than lanthanum also have attributes that are similar to lanthanum.

A rare earth metal such as lanthanum is a material in which high purification is difficult to achieve since it is easily oxidized during the refining process. In addition, if a rare earth metal such as lanthanum is left in the atmosphere, there is a problem in that the handling thereof is difficult since it will become oxidized and discolored in a short period of time.

In recent years, thinning of a gate insulator film in the next-generation MOSFET is being demanded, but with the SiO₂ that has been conventionally used as the gate insulator film, the leak current will increase due to the tunnel effect, and normal operation is becoming difficult.

Thus, as a substitute for the SiO₂ described above, HfO₂, ZrO₂, Al₂O₃ and La₂O₃ with high dielectric constant, high thermal stability, and high energy barrier against the holes and electrons in the silicon have been proposed. In particular, among the foregoing materials, La₂O₃ is valued highly, and a research paper that studied its electrical properties and use as a gate insulator film in the next-generation MOSFET has been reported (refer to Non-Patent Document 1). Here, with Non-Patent Document 1, while the subject of research is a La₂O₃ film, the raw material is lanthanum or a lanthanum target. However, Non-Patent Document 1 does not make any reference to the hygroscopic property and degradation phenomenon of a lanthanum or lanthanum oxide target.

It could be said that rare earth metals such as lanthanum and their oxides are still in the research phase, but when studying the properties of such rare earth metal and their oxides, if a rare earth metal or its oxide, in particular if lanthanum or lanthanum oxide itself exists as a sputtering target material, it is possible to form a thin film of such lanthanum oxide on a substrate. It will also be easy to study the behavior at the interface with the silicon substrate, and additionally study the properties of a high-dielectric gate insulator film or the like by forming a rare earth metal compound, and there is also a significant advantage in that the flexible use of the target as a product will increase.

Nevertheless, even if a lanthanum sputtering target is prepared, as described above, it becomes oxidized in a short period of time in the atmosphere. Generally, a stable oxide layer is formed on a metal target surface, but since it is extremely thin under normal circumstances, it peels off during the initial stage of sputtering, and will not affect the sputtering characteristics significantly. However, with a lanthanum sputtering target, the oxide layer becomes thick and deteriorates the electrical conductivity, and thereby causes defective sputtering.

In addition, if the lanthanum sputtering target is left in the atmosphere for a long period of time, it reacts with the moisture in the air and becomes covered with white hydroxide powder, and ultimately becomes degraded, and it may even cause a problem of not allowing normal sputtering to be performed. Thus, once the target is prepared, it is necessary to take measures for preventing oxidation and hydration by immediately performing vacuum packing or coating the target with fats and oils.

As a method of storing rare earth metals, the standard method is to store the rare earth metals in mineral oil in order to prevent such rare earth metals from coming in contact with the atmosphere. However, when using a rare earth metal as a sputtering target, it is necessary to clean the target before its use in order to remove the mineral oil. Here, there is a problem in that the cleaning of the target itself is difficult due to its reactivity with oxygen, moisture, and carbon dioxide.

Under normal circumstances, it is necessary to store and pack the target via vacuum packing. However, even in a state where the target is vacuum packed, since degradation caused by hydroxylation will progress even with a small amount of moisture that permeates the film to be used, it was difficult to store the sputtering target for a long period of time in a usable condition.

When reviewing the conventional background art, there are the following methods; namely, a method of covering the hollow cathode-type sputtering target with a resin bag (refer to Patent Document 1), a method of affixing a plastic protective film to the target (refer to Patent Document 2), a method of packaging the target using a film having a surface that is free from detachable particles (refer to Patent Document 3), a method of using a transparent acrylic resin cover to prepare a target storage container and screwing shut the storage container (refer to Patent Document 4), and a method of filling the sputtering target in a bag-shaped object (refer to Patent Document 5).

Nevertheless, since the foregoing Patent Documents seal the target using a resin cover or a resin film, they are insufficient as a method of storing a metal lanthanum target.

There is a report that hydration can be inhibited by placing the lanthanum oxide powder in a hydrofluoric acid aqueous solution and forming a lanthanum fluoride film on the powder surface (refer to Patent Document 6). Although this is of some reference, since its object is lanthanum oxide powder, it is unclear as to whether it can be applied to a target in the shape of or block.

In light of the foregoing circumstances, the present applicant developed a method of storing a sputtering target made of lanthanum oxide, wherein the lanthanum oxide target and lanthanum oxide powder are charged in a vacuum pack with an oxygen transmission rate of 0.1 cm³/m² per 24 h at 1 atm or less and a moisture vapor transmission rate of 0.1 g/m² per 24 h or less, and, after charging the target and powder, subjecting the vacuum pack to vacuum suction and sealing for storage (refer to Patent Document 7).

This storage method is extremely effective and yields a dramatically superior effect, in comparison to conventional technologies, of being able to inhibit the degradation phenomenon caused by hydration (hydroxylation), and the degradation phenomenon caused by the formation of carbonate. Nevertheless, it is necessary to further improve this storage method for metal lanthanum.

[Prior Art Documents]
[Patent Document 1] International Publication No.WO2005/037649
[Patent Document 2] Japanese Unexamined Patent Application Publication No. 2002-212718
[Patent Document 3] Japanese Unexamined Patent Application Publication No. 2001-240959
[Patent Document 4] Japanese Unexamined Patent Application Publication No.H08-246145
[Patent Document 5] Japanese Unexamined Patent Application Publication No.H04-231461
[Patent Document 6] Japanese Unexamined Patent Application Publication No. H 10-87326
[Patent Document 7] International Publication No. WO2010/050409

[Non-Patent Document 1] Written by Eisuke Tokunaga and two others, "Research on Oxide Material for High-k Gate Insulator Film" The Institute of Electrical Engineers of Japan, Research Paper of Electronic Materials, Vol. 6-13, Pages 37 to 41, Published on September 21, 2001

### SUMMARY OF THE INVENTION

### [Problems to be Solved by the Invention]

An object of this invention is to provide technology for enabling the long-term storage of a sputtering target in a usable state by devising the method of storing a metal lanthanum target as a rare earth metal, and thereby inhibiting the degradation phenomenon of the target caused by oxidation due to residual air or inclusion of air, and the degradation phenomenon caused by the formation of carbonate.

### [Means to Solve the Problems]

The present invention provides:
1) A method of storing a metal lanthanum sputtering target, wherein a surface of a metal lanthanum target to be stored is processed so as to achieve a roughness Ra of 1 µm or less, the metal lanthanum target having a surface roughness Ra of 1 µm or less is subsequently charged in a vacuum pack with an oxygen transmission rate of 0.1 cm³/m² per 24 h at 1atm or less and a moisture vapor transmission rate of 0.1 g/m² per 24 h or less, and the vacuum pack is thereafter subject to vacuum suction and sealing for storage.

A significant feature of the present invention is to refine the roughness of the surface of the lanthanum target, and this considerably increases the effect of inhibiting the degradation phenomenon of the target caused by hydration (hydroxylation) and the degradation phenomenon caused by the formation of carbonate since the area to come into contact with the atmosphere can be reduced.

Moreover, a more preferable condition of the vacuum pack is that it comprises properties where its oxygen transmission rate is 0.07 cm³/m² per 24 h at 1atm or less and its moisture vapor transmission rate is 0.02 g/m² per 24 h or less. The same applies to the vacuum pack explained below.

The present invention provides:
2) A method of storing a metal lanthanum sputtering target, wherein a lanthanum fluoride coating is formed on a surface of a metal lanthanum target to be stored, the metal lanthanum target to which the lanthanum fluoride coating was formed is subsequently charged in a vacuum pack with an oxygen transmission rate of 0.1 cm³/m² per 24 h at 1 atm or less and a moisture vapor transmission rate of 0.1 g/m² per 24 h or less, and the vacuum pack is thereafter subject to vacuum suction and sealing for storage.

A significant feature of this invention is that a lanthanum fluoride coating is formed, in advance, on the surface of the metal lanthanum target to be stored, and it is thereby possible to considerably improve the inhibition effect of the degradation phenomenon caused by hydration (hydroxylation), and the degradation phenomenon caused by the formation of carbonate.

The present invention provides:
3) A method of storing a metal lanthanum sputtering target, wherein a surface of a metal lanthanum target to be stored is processed so as to achieve a roughness Ra of 1 µm or less, a lanthanum fluoride coating is formed on the surface thereof, the metal lanthanum target to which the lanthanum fluoride coating was formed are subsequently charged in a vacuum pack with an oxygen transmission rate of 0.1 cm³/m² per 24 h at 1 atm or less and a moisture vapor transmission rate of 0.1 g/m² per 24 h or less, and the vacuum pack is thereafter subject to vacuum suction and sealing for storage.

This invention combines the conditions of 1) and 2) above, and is even more effective since it possesses the advantages of both 1) and 2) above.

The present invention provides:
4) The method of storing a metal lanthanum target according to any one of 1) to 3) above, wherein purity of the metal lanthanum target is 3N or higher.

The present invention provides:
5) A metal lanthanum sputtering target sealed in a vacuum pack for storage, wherein a surface of the metal lanthanum target to be stored is processed so as to achieve a roughness Ra of 1 µm or less, an oxygen transmission rate of the vacuum pack is 0.1 cm³/m² per 24 h at 1 atm or less and a moisture vapor transmission rate of the vacuum pack is 0.1 g/m² per 24 h or less, and the metal lanthanum target having a surface roughness Ra of 1 µm or less is charged and sealed in the vacuum pack.

The present invention provides:
6) A metal lanthanum sputtering target sealed in a vacuum pack for storage, wherein a lanthanum fluoride coating is formed on a surface of the metal lanthanum target to be stored, an oxygen transmission rate of the vacuum pack is 0.1 cm³/m² per 24 h at 1 atm or less and a moisture vapor transmission rate of the vacuum pack is 0.1 g/m² per 24 h or less, and the metal lanthanum target to which the lanthanum fluoride coating was formed is charged and sealed in the vacuum pack.

The present invention provides:
7) A metal lanthanum sputtering target sealed in a vacuum pack for storage, wherein a surface of the metal lanthanum target to be stored is processed so as to achieve a roughness Ra of 1 µm or less, a lanthanum fluoride coating is formed on the surface thereof, an oxygen transmission rate of the vacuum pack is 0.1 cm³/m² per 24 h at 1 atm or less and a moisture vapor transmission rate of the vacuum pack is 0.1 g/m² per 24 h or less, and the metal lanthanum target to which the lanthanum fluoride coating was formed are charged and sealed in the vacuum pack.

The present invention provides:
8) The metal lanthanum sputtering target sealed in a vacuum pack according to any one of 5) to 7) above, wherein purity of the metal lanthanum target is 3N or higher.

The present invention provides:
9) A thin film formed by sputtering the metal lanthanum sputtering target sealed in a vacuum pack according to any one of 5) to 8) above, wherein the metal lanthanum target is sputtered after being stored, and thereafter being released from its vacuum seal and removed from the vacuum pack.

### [Effect of the Invention]

When sealing and storing a conventional target made of a rare earth metal or its oxide using a hermetic container or a plastic film, if it is left unattended for a long period of time, it will react with oxygen and moisture and become covered with white hydrate (hydroxide) powder, and there is a problem in that normal sputtering cannot be performed. However, a significant effect of being able to avoid those problems with a metal lanthanum sputtering target in which the surface roughness Ra of the metal lanthanum target to be stored is refined, or a lanthanum fluoride film is formed in advance on a surface thereof, or the surface roughness is refined and a lanthanum fluoride film is formed on the surface thereof at the same time; and then sealed in a vacuum pack and stored can be stored for a long period of time, and yields.

### BRIEF DESCRIPTION OF DRAWING

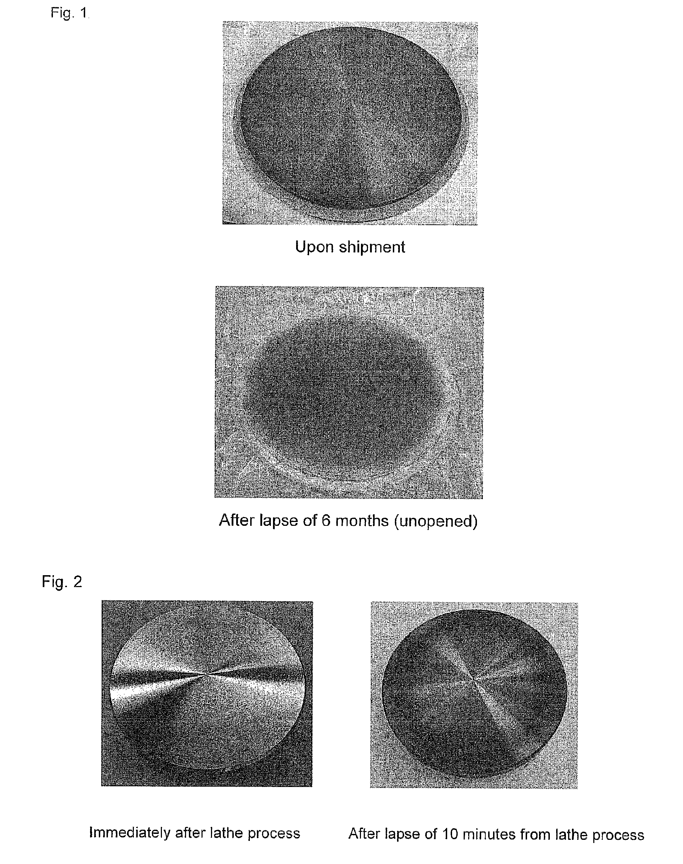

Fig. 1 is a diagram (photograph) showing, in a case of vacuum-packing a La target, the state of the unopened target upon shipment and after the lapse of 6 months.
Fig. 2 is a diagram (photograph) showing the state of the target immediately after the La target was subject to the lathe process, and after the lapse of 10 minutes from the lathe process.

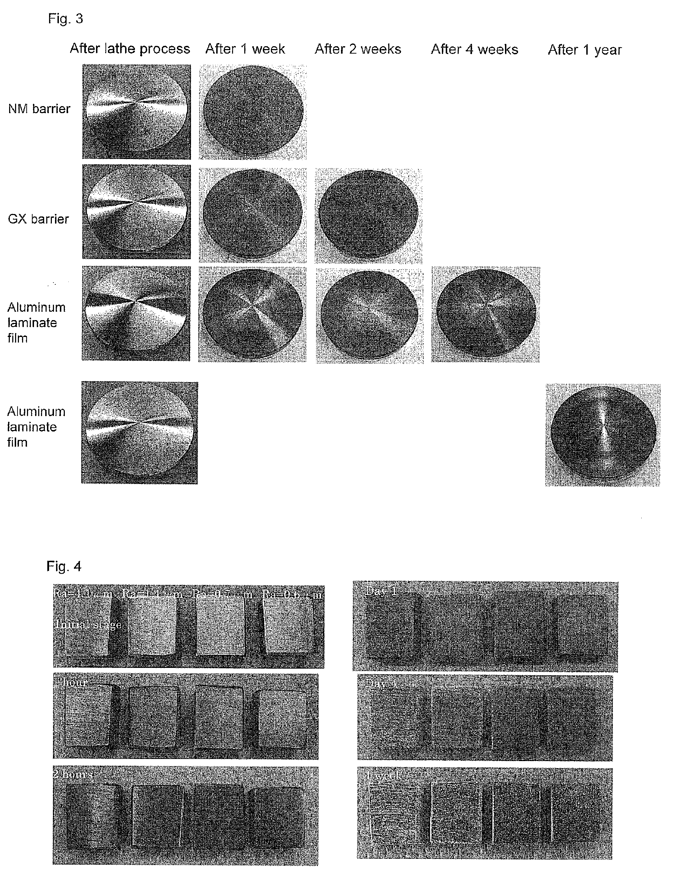

Fig. 3 is a diagram (photograph) showing the change in the surface condition upon vacuum-packing a La target with an NM barrier (Mitsubishi Plastics, silica vapor-deposited polyester film, Product name: Techbarrier (registered trademark)), GX barrier (Toppan Printing, alumina vapor-deposited polyester film, Product name: GX film (transparent ultra-high barrier film)), and an aluminum laminate film, respectively.
Fig. 4 is a diagram (photograph) showing the change in the degradation phenomenon of the La target upon changing the surface roughness; specifically, a diagram (photograph) of "initial stage", "1 hour" and "2 hours" from the upper left, a diagram (photograph) of "day 1 ", "day 4" and "1 week" from the upper right, and a diagram (photograph) of "Ra = 4.1 µm", "Ra = 1.1 µm", "Ra = 0.7 µm", "Ra = 0.6 µm" from the left side in the respective diagrams (photographs).

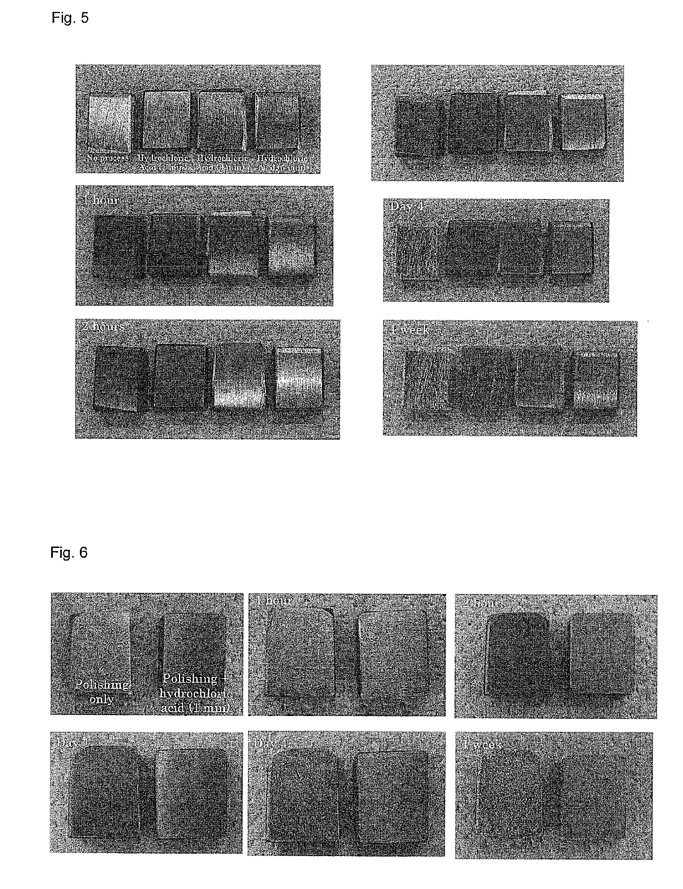

Fig. 5 shows a diagram (photograph) showing the change in the degradation phenomenon of the La target when the surface roughness Ra is 3 to 4 µm or less; specifically, a diagram (photograph) of "initial stage", "1 hour" and "2 hours" from the upper left, a diagram (photograph) of "day 1", "day 4" and "1 week" from the upper right, and a diagram (photograph) of "no process", "hydrochloric acid (1 min)", "hydrochloric acid (3 min)", "hydrochloric acid (5 min)" from the left side in the respective diagrams (photographs).
Fig. 6 is a diagram (photograph) showing the temporal change of powdering based on whether or not a fluoride film coating is formed on the metal lanthanum (Ra = 0.7 µm) in which the surface was polished using sandpaper of #1500; specifically, a diagram (photograph) of "initial stage", "1 hour" and "2 hours" from the upper left, a diagram (photograph) of "day 1 ", "day 4" and "1 week" from the upper right, and a diagram (photograph) of "polishing only" and "polishing + hydrochloric acid (1 min)" from the left side in the respective diagrams (photographs).

### DETAILED DESCRIPTION OF THE INVENTION

Lanthanum is known to be extremely weak against oxidation. Thus, the challenge to date was how to prevent the oxidation of lanthanum, and how to store lanthanum in an environment with minimal moisture and oxygen.

The degradation phenomenon of a conventional metal lanthanum target and means for resolving this problem are now explained below with reference to diagrams and the like including specific examples and comparative examples.

In recent years, demands for a La-based target for use as a work function coordination layer (La₂O₃) of a PMOS high-k material are increasing. When La is stored in the atmosphere, it foremost changes to La₂O₃, and then rapidly changes to La(OH)₃, and ultimately deteriorates into powder form.

For example, if a La target is vacuum-packed and shipped to a customer, oxidation would occur during the period from shipment to opening of the vacuum pack, and problems such as partial powdering, and generation of numerous particles would arise. Fig. 1 shows the condition thereof. The top diagram is a photograph showing the surface condition upon shipment, and the bottom diagram is a photograph showing the surface condition of an unopened target after 6 months have lapsed from shipment.

As evident from Fig. 1, oxidation at the outer edge portion of the target is considerable, and subject to the degradation phenomenon. While the surface condition can be recovered to a certain degree, excluding the outer edge portion, based on surface cleaning, there is a problem in that the target must be subject to surface cleaning with each use.

In order to resolve the foregoing problem, it is important to select the appropriate vacuum packing material and improve the condition of the lanthanum surface.

Upon producing a metal lanthanum target, it is desirable to use high purity lanthanum with minimal impurity, but used may be a material having a purity level of 3N (99.9%) excluding rare earth elements other than La and gas components. The lanthanum raw material is subject to the processes of vacuum melting, forging and rolling, and ultimately processed into a target shape.

Fig. 2 is a diagram showing that a La target is extremely vulnerable to oxidation in the atmosphere. While the surface is basically silver after the lathe process, the surface becomes discolored (oxidized) to a black-and-blue color only after leaving it in the atmosphere for roughly 10 minutes. When the oxidation advances further, the surface becomes powderized. Thus, it is important to block the air with a vacuum pack for inhibiting powderization.

Fig. 3 is a diagram showing the results of vacuum-packing the La target using various types of vacuum packing material, and examining the rate at which the surface oxidation advances. The silver portion shows the place that is free of corrosion, and the blackened portion shows the state where powderization is advancing. With the NM barrier, the front face became blackened and oxidized in 1 week, and the outer edge has started to become powderized. With the GX barrier, while a silver surface can be seen at the center after 1 week, the outer edge has started to become powderized after 2 weeks.

Two types of aluminum laminate film were prepared; namely, one type for observing the surface condition from immediately after the lathe process to the lapse of 4 weeks, and another type for observing the surface condition immediately after the lathe process and after the lapse of 1 year. Consequently, with an aluminum laminate film, the silver portion remained even after the lapse of 1 year, and the indication of powderization was extremely small. Based on the foregoing results, it could be said that an aluminum laminate film is effective as the vacuum packing material.

Table 1 shows the properties of the various types of vacuum packing material. The reason for the difference shown in Fig. 3 even though the GX barrier and the aluminum laminate film have nearly the same values is considered to be because, in the case of the GX barrier, the packing material is pulled during the vacuum packing process, which causes certain parts to become partially thin, and this results in the increased permeation of oxygen and moisture.

Based on the results of Table 1 and the vacuum pack dependency of surface oxidation, it can be understood that a vacuum packing material with an oxygen transmission rate of 0.07 cm³/m² per 24 h at 1 atm m or less and a moisture vapor transmission rate of 0.02 g/m² per 24 h or less is desirably used.

**[Table 1]**

| | Barrier property | | Moisture content (wt%) |
|---|---|---|---|
| | Moisture permeability (g/m² per 24h) | Oxygen permeability (cm³/m² per 24h at 1 atm) | |
| NM barrier | 0.32 | 0.24 | 0.42 |
| GX barrier | <0.02 | 0.063 | 0.36 |
| Aluminum laminate film | <0.02 | 0.047 | 0.15 |

### (Surface roughness Ra dependency and effect)

While it has been explained that the surface oxidation can be inhibited by blocking the air with a vacuum pack using an appropriate vacuum packing material, it would be meaningless if the oxidation advances during the period after processing up to the vacuum packing.

Since surface oxidation is considered to be dependent on the contact area of the atmosphere and the lanthanum surface, the relation with the worked surface of the metal lanthanum was examined. Fig. 4 shows the surface roughness after processing and the change in the surface condition (powderization).

Upon polishing the metal lanthanum surface with sandpaper of #80, #240, #600, #1500 and measuring the surface roughness Ra, the results were 4.1 µm, 1.1 µm, 0.7 µm, and 0.6 µm, respectively. These were left in the atmosphere to observe the change in the surface powderization.

The room was set to a temperature of around 23°C and dry-controlled (humidity of roughly 30 to 40%). The time of year was November. While there was no drastic difference after day 1, a difference started to appear between metal lanthanum having a surface roughness Ra of 1 µm or more and metal lanthanum having a surface roughness Ra of 1 µm or less on day 4, and the difference became considerable after 1 week. Consequently, it can be understood that the adjustment of the roughness of the metal lanthanum target surface is important for inhibiting the degradation phenomenon, and the roughness Ra of the lanthanum target surface is preferably 1 µm or less, and more preferably 0.7 µm or less.

### (Effect of fluoride film coating)

A fluoride film was coated on the surface of the metal lanthanum target and left in the atmosphere, and the change in the surface powderization was observed. The surface roughness Ra in the foregoing case was 3 to 4 µm.

The fluoride film coating can be realized immersing the metal lanthanum target in hydrofluoric acid. The time of immersing the metal lanthanum target in hydrofluoric acid was 1 minute, 3 minutes, and 5 minutes, respectively. The surface color changes when the metal lanthanum target is immersed in hydrofluoric acid. After 1 minute the surface turns bluish purple, and the color becomes lighter as the immersion time becomes longer, i.e., 3 minutes, 5 minutes, and becomes a silver gray color.

Fig. 5 shows the temporal change of powderization upon subjecting the respective metal lanthanum targets to hydrofluoric acid treatment, and changing the hydrofluoric acid treatment time. While there was no drastic difference after day 1, a difference started to appear from day 4 between the metal lanthanum target that was immersed in hydrofluoric acid for 5 minutes and the metal lanthanum target that was not subject to hydrofluoric acid treatment, and even between the metal lanthanum target that was immersed in hydrofluoric acid for 1 minute and the metal lanthanum target that was not subject to hydrofluoric acid treatment. While there is no limitation in the time of immersing the metal lanthanum target in hydrofluoric acid, the results are certain when performed for 5 minutes, but it can be seen that results can also be obtained even when performed only for 1 minute. Thus, the hydrofluoric acid treatment time will suffice so as long as it is at least 1 minute.

### (Effect of combined use of adjustment of surface roughness and formation of fluoride film coating)

Since it has been confirmed that the refining of the worked surface roughness is effective, and that the formation of a fluoride film coating is also effective, the combined use of such refinement of the worked surface roughness and the formation of a fluoride film coating was tested. Fig. 6 shows the temporal change of powderization in the case of forming, and not forming, a fluoride film coating on metal lanthanum in which its surface was polished with sandpaper of #1500. The surface roughness Ra was 0.7 µm. A difference started to appear from day 4, and the metal lanthanum with no fluoride film coating was subject to powderization after 1 week.

Hence, it was confirmed that the combined use of the adjustment of the surface roughness ad the formation of a fluoride film coating is even more effective.

A La target easily reacts with moisture and oxygen in the atmosphere. The powderization of the La target can be effectively inhibited by controlling the surface roughness Ra after the processing of the La target, or forming a fluoride film coating thereon, or combining the foregoing processes. In addition, by vacuum-packing the La target with an appropriate material after the foregoing process or processes, advancement of the surface oxidation (degradation phenomenon) from the processing to the start of use of the target can be inhibited.

The foregoing effects are not limited to lanthanum, but similar effects can be obtained in rare earths and rare earth alloys other than La, as well as in rare earths and rare earth alloys containing lanthanum; and the present invention is effective in preventing the oxidation of these substances.

### [Industrial Applicability]

If a rare earth metal oxide sputtering target, particularly a metal lanthanum sputtering target is left in the atmosphere for a long period of time, it reacts with the moisture in the air and becomes covered with white hydroxide powder, which conventionally, is a problem in that normal sputtering cannot be performed. Nevertheless, the method of storing a metal lanthanum sputtering target of the present invention is able to avoid the foregoing problems.

With the method of storing a metal lanthanum target according to the present invention, basically, the surface roughness Ra of a metal lanthanum target is processed to be 1 µm or less, or a fluoride film coating is formed on the surface thereof, or a metal lanthanum target subject to both of the foregoing processes is inserted into a vacuum packing material, and the vacuum pack is subject to vacuum suction and sealing for storage. It is thereby possible to effectively inhibit the condition where the target reacts with the oxygen and moisture in the atmosphere and becomes covered with white oxide powder. Thus, targets can be stably supplied as an electronic material such as a metal gate material or a high-dielectric material (High-k); and in this sense, the present invention is extremely useful industrially.

## Claims

1. A method of storing a metal lanthanum sputtering target, wherein a surface of a metal lanthanum target to be stored is processed so as to achieve a roughness Ra of 1 µm or less, the metal lanthanum target having a surface roughness Ra of 1 µm or less is subsequently charged in a vacuum pack with an oxygen transmission rate of 0.1 cm³/m² per 24 h at 1 atm or less and a moisture vapor transmission rate of 0.1 g/m² per 24 h or less, and the vacuum pack is thereafter subject to vacuum suction and sealing for storage.

2. A method of storing a metal lanthanum sputtering target, wherein a lanthanum fluoride coating is formed on a surface of a metal lanthanum target to be stored, the metal lanthanum target to which the lanthanum fluoride coating was formed is subsequently charged in a vacuum pack with an oxygen transmission rate of 0.1 cm³/m² per 24 h at 1 atm or less and a moisture vapor transmission rate of 0.1 g/m² per 24 h or less, and the vacuum pack is thereafter subject to vacuum suction and sealing for storage.

3. A method of storing a metal lanthanum sputtering target, wherein a surface of a metal lanthanum target to be stored is processed so as to achieve a roughness Ra of 1 µm or less, a lanthanum fluoride coating is formed on the surface thereof, the metal lanthanum target to which the lanthanum fluoride coating was formed and lanthanum oxide powder are subsequently charged in a vacuum pack with an oxygen transmission rate of 0.1 cm³/m² per 24 h at 1 atm or less and a moisture vapor transmission rate of 0.1 g/m² per 24 h or less, and the vacuum pack is thereafter subject to vacuum suction and sealing for storage.

4. The method of storing a metal lanthanum target according to any one of claims 1 to 3, wherein purity of the metal lanthanum target is 3N or higher.

5. A metal lanthanum sputtering target sealed in a vacuum pack for storage, wherein a surface of the metal lanthanum target to be stored is processed so as to achieve a roughness Ra of 1 µm or less, an oxygen transmission rate of the vacuum pack is 0.1 cm³/m² per 24 h at 1 atm or less and a moisture vapor transmission rate of the vacuum pack is 0.1 g/m² per 24 h or less, and the metal lanthanum target having a surface roughness Ra of 1 µm or less is charged and sealed in the vacuum pack.

6. A metal lanthanum sputtering target sealed in a vacuum pack for storage, wherein a lanthanum fluoride coating is formed on a surface of the metal lanthanum target to be stored, an oxygen transmission rate of the vacuum pack is 0.1 cm³/m² per 24 h at 1 atm or less and a moisture vapor transmission rate of the vacuum pack is 0.1 g/m² per 24 h or less, and the metal lanthanum target to which the lanthanum fluoride coating was formed is charged and sealed in the vacuum pack.

7. A metal lanthanum sputtering target sealed in a vacuum pack for storage, wherein a surface of the metal lanthanum target to be stored is processed so as to achieve a roughness Ra of 1 µm or less, a lanthanum fluoride coating is formed on the surface thereof, an oxygen transmission rate of the vacuum pack is 0.1 cm³/m² per 24 h at 1 atm or less and a moisture vapor transmission rate of the vacuum pack is 0.1 g/m² per 24 h or less, and the metal lanthanum target to which the lanthanum fluoride coating was formed and lanthanum oxide powder are charged and sealed in the vacuum pack.

8. The metal lanthanum sputtering target sealed in a vacuum pack according to any one of claims 5 to 7, wherein purity of the metal lanthanum target is 3N or higher.

9. A thin film formed by sputtering the metal lanthanum sputtering target sealed in a vacuum pack according to any one of claims 5 to 8, wherein the metal lanthanum target is sputtered after being stored, and thereafter being released from its vacuum seal and removed from the vacuum pack.
